**Europäisches Patentamt**

**European Patent Office**

**Office européen des brevets**

(19)

(11) **EP 0 930 704 A2**

(12) **EUROPÄISCHE PATENTANMELDUNG**

(43) Veröffentlichungstag:
21.07.1999 Patentblatt 1999/29

(51) Int. Cl.$^6$: **H03H 17/02**

(21) Anmeldenummer: 98122325.8

(22) Anmeldetag: 24.11.1998

(84) Benannte Vertragsstaaten:
**AT BE CH CY DE DK ES FI FR GB GR IE IT LI LU
MC NL PT SE**
Benannte Erstreckungsstaaten:
**AL LT LV MK RO SI**

(30) Priorität: **16.01.1998 DE 19801325**

(71) Anmelder: **ROBERT BOSCH GMBH
70442 Stuttgart (DE)**

(72) Erfinder:
• **Gebauer, Thomas
71573 Allmersbach i.Tal (DE)**
• **Goeckler, Heinz
71522 Backnang (DE)**

(54) **Polyphasenfilter zur Abtastratenänderung und frequenzumsetzung**

(57) Ein Polyphasenfilter mit komplexen Koeffizienten wandelt ein komplexwertiges Eingangssignals $X(kT_1)$ unter Veränderung der Abtastfrequenz $1/T$ in ein komplexwertiges Ausgangssignal $Y(kT_2)$, wobei der Faktor zur Veränderung der Abtastfrequenz $M = T1/T2$ für $T1>T2$ (Interpolation) bzw. $M = T2/T1$ für $T2>T1$ beträgt, wobei M eine ganze Zahl > 2 ist, und die komplexwertigen Koeffizienten $\underline{h}(k)$ mit $k \in \{-(N-1)/2,..., -1, 0, 1, ..., (N-1)/2\}$ für einen Filter mit ungerader Filterlänge und mit $k \in (-N/2,..., -1, 0, 1, N/2-1\}$ für eine ungerade Filterlänge sich aus der Beziehung

$$\underline{h}(k) = h(k)\, e^{j(2\pi k f_m/f_A + \varphi_0)}$$
$$= h(k)\, e^{j(2\pi km/M + l\pi/2)}$$
$$= h(k)\, j^{\,l}\, e^{j2\pi km/M}$$

mit: $\varphi_0 = l\pi/2$, $l \in \{..., -1, 0, 1, ...\}$ ergeben.

FIG. 1

EP 0 930 704 A2

**Beschreibung**

Die Erfindung betrifft einen Bandpaßfilter einer Polyphasenstruktur zur Änderung der Abtastfrequenz und zwar für den Dezimations- oder den Integrationsfall entsprechend dem Oberbegriff des Anspruchs 1.

Bandpaßfilter (BP) mit komplexen Koeffizienten zur Änderung der Abtastfrequenz um den Faktor 2 sind bekannt, siehe beispielsweise EPA 0 339 037 B1 mit einem reellen Eingangs- und einem komplexen Ausgangssignal bzw. umgekehrt und DE PS 37 05 209 C2 mit einem komplexen Eingangs- und einem komplexen Ausgangssignal. Diese bekannten Bandpaßfilter bewirken aber keine Frequenzverschiebung, bzw. nur mit Hilfe einer zusätzlichen Mischervorrichtung. Außerdem ist der Faktor zur Änderung der Abtastrate auf M = 2 beschränkt. Die Realisierung dieser Bandpaßfilter ist aufgrund von zwei Maßnahmen besonders aufwandsgünstig: 1) die Bandpaß-Mittenfrequenz ist auf $\pm f_A/4$ beschränkt und 2) diese Filter sind durch eine Frequenztransformation von einem nichtrekursiven Halbband-Prototypfilter abgeleitet, für dessen N ungerade Koeffizienten gilt $h(k) = h(-k)$, wobei $-(N-1)/2 \le k \le (N-1)/2$ und $h(k) = 0$ für $k = \pm 2, \pm 4, \pm 6, \ldots$.

Aus DE PS 40 26 476 C2 ist die sehr allgemeine Struktur eines Polyphasenfilters mit komplexen Koeffizienten bekannt. Dabei ist nichts ausgesagt über die Werte der Koeffizienten, sondern lediglich eine Struktur veröffentlicht, mit der beliebige Übertragungsfunktionen (Tiefpaß, Bandpaß, Hochpaß, etc.) realisierbar sind, ohne daß neben strukturellen Maßnahmen eine globale Aufwandsminimierung durchgeführt wurde.

Es soll ein Bandpaß-Filter zur Änderung der Abtastfrequenz um einen ganzzahlige Faktor $M \ge 3$ angegeben werden, wobei aufgrund der Abtastratenänderung eine Frequenzverschiebung des gefilterten Signalspektrums in einem gewünschten Sinne erfolgt, ohne daß dafür gesonderte Mischervorrichtungen erforderlich sind.

Diese Bandpaß-Filter haben im allgemeinen komplexwertige Koeffizienten, was eine Verdopplung oder gar Vervierfachung der Zahl der Multiplizierer bewirkt.

Im Dezimationsfall D (Abtastratenverminderung) soll das Nutzspektrum zu tieferen Frequenzen verschoben werden; im Interpolationsfall I (Abtastratenerhöhung) soll das Nutzspektrum zu höheren Frequenzen verschoben werden.

Als Ein- und Ausgangssignale sind alle möglichen Kombinationen von reellwertigen (R) und komplexwertigen (C) Signalen möglich, wobei die auftretenden Kombinationen von der vorgegebenen BP-Mittenfrequenz abhängen.

Zur Überwindung der starken Einschränkungen der Wahl der BP-Mittenfrequenz soll bei der erfindungsgemäßen Lösung die BP-Mittenfrequenz zu

$$f_m = m \, (f_A/M) \text{ mit } m \in \{1, \ldots, M\text{-}1\} \text{ (Fall a)} \tag{1}$$

wählbar sein; dabei ist $M > 2$ der ganzzahlige Faktor zur Änderung der Abtastfrequenz $f_A$. Der Entwurf des BP ist dabei stets auf die hohe Abtastfrequenz $f_A$ bezogen und zwar sowohl für den Dezimationsfall D (Abtastfrequenz wird vermindert) als auch den Interpolationsfall I (Abtastfrequenz wird erhöht). Ferner sollen stets auch die BP-Mittenfrequenzen

$$f_m = i(f_A/4) \text{ mit } i \in \{1, 2, 3\} \text{ (Fälle b, c)} \tag{2}$$

unabhängig vom Wert von M wählbar sein. Ist M eine Viererzahl (4,8,12,...), so sind die Fälle b, c in Fall a enthalten. Nachfolgend wird der Fall, daß M zwar keine Viererzahl aber gerade ist, als Fall b bezeichnet; schließlich wird M ungerade als Fall c behandelt.

Der Erfindung liegt daher die Aufgabe zugrunde, unter optimaler Nutzung obiger BP-Mittenfrequenzen aufwandsminimale Bandpaßfilter anzugeben, die die obigen Forderungen erfüllen.

Die Aufgabe wird durch den Gegenstand des Anspruchs 1 gelöst. Bevorzugte Ausgestaltungen der Erfindung sind Gegenstand der Unteransprüche.

Gegenüber den bekannten Strukturen ergeben sich durch die erfindungsgemäßen Lösungen deutliche Aufwandsvorteile, d.h. deutlich einfachere Verknüpfungsstrukturen, so daß sich einfache hardwaremäßige Lösungen ergeben. Ferner ist die grundsätzliche Beschränkung der Zahl der Koeffizienten (Filterlänge) auf eine ungerade Zahl wie bei den bekannten Bandpaßfiltern aufgehoben und die Filterlängen N können in der erfindungsgemäßen Lösung gerade oder ungerade, also frei wählbar sein.

Das erfindungsgemäße Bandpaß-Filter umfaßt komplexe Koeffizienten zum Umwandeln eines komplexwertigen Eingangssignals X(kT) unter Verminderung der Abtastfrequenz $f_A = 1/T$ in ein komplexwertiges Ausgangssignal Y(kMT), wobei der Faktor zur Verminderung der Abtastfrequenz M beträgt, M eine ganze Zahl > 2 ist, und die komplexwertigen Koeffizienten $\underline{h}(k)$ mit $k \in \{-(N-1)/2, \ldots, -1, 0, 1, \ldots, (N-1)/2\}$ für einen Filter mit ungerader Filterlänge und mit $k \in (-N/2, \ldots, -1, 0, 1, N/2\text{-}1\}$ für eine ungerade Filterlänge sich aus einem reellen Prototypfilter h(k) mit der Modulationsfrequenz $f_m$ nach Gl. 1 und einer Phase $\varphi_0 = l\pi/2$, $l \in \{\ldots, -1, 0, 1, \ldots\}$ berechnet:

$$\begin{aligned}
\underline{h}(k) &= h(k)\, e^{j(2\pi k f_m/f_A + \varphi_0)} \\
&= h(k)\, e^{j(2\pi km/M + l\pi/2)} \\
&= h(k)\, j^l\, e^{j2\pi km/M}
\end{aligned} \tag{3}$$

Ein Bandpaß-Filter gemäß der Erfindung zur Erhöhung der Abtastfrequenz im Interpolationsfall ergibt sich durch eine übliche Transponierung der Struktur des obigen Filters.

Bevorzugte Ausführungsformen der Erfindung werden nachfolgend anhand der Zeichnungen erläutert, in denen:

Fig. 1 zeigt ein Blockschaltbild einer ersten Ausführungsform des erfindungsgemäßen Bandpaßfilters einer ungeraden Filterlänge zur Verminderung der Abtastfrequenz mit reellwertigen Eingangssignalen und komplexwertigen Ausgangssignalen;

Fig. 2 zeigt ein Blockschaltbild einer zweiten Ausführungsform des erfindungsgemäßen Bandpaßfilters einer geraden Filterlänge zur Verminderung der Abtastfrequenz mit reellwertigen Eingangssignalen und komplexwertigen Ausgangssignalen;

Fig. 3a zeigt in schematischer Darstellung die Wirkung des erfindungsgemäßen Bandpaßfilters auf ein komplexwertiges Eingangssignal mit den Spektren $\underline{X}(e^{j\Omega})$;

Fig. 3b zeigt das komplexwertige gefilterte Ausgangssignalspektrum;

Fig. 4 zeigt ein Blockschema eines erfindungsgemäßen Bandpaß-Filters zur Umwandlung komplexwertiger Eingangssignale in komplexwertige Ausgangssignale;

Fig. 5 zeigt ein Blockschema eines erfindungsgemäßen Bandpaß-Filters für den Fall b mit M gerade;

Figuren 6a und 6b zeigen die Wirkung eines Filters nach Fig. 5 auf ein Eingangssignalspektrum und dessen Ausgangssignalspektren;

Fig. 7 zeigt ein Blockschema des Filters nach Fig. 5 mit ungeradem M, und

Figuren 8a und 8b zeigen die Wirkung eines Filters nach Fig. 7 auf ein Eingangssignal und dessen Ausgangssignal.

Es wird zunächst der Fall a mit der Verminderung der Abtastrate (Fall D) behandelt. Aus Darstellungsgründen ist eine weitere Fallunterscheidung zu berücksichtigen: Fall G für eine gerade Filterlänge N und den Fall U für eine ungerade Filterlänge N.

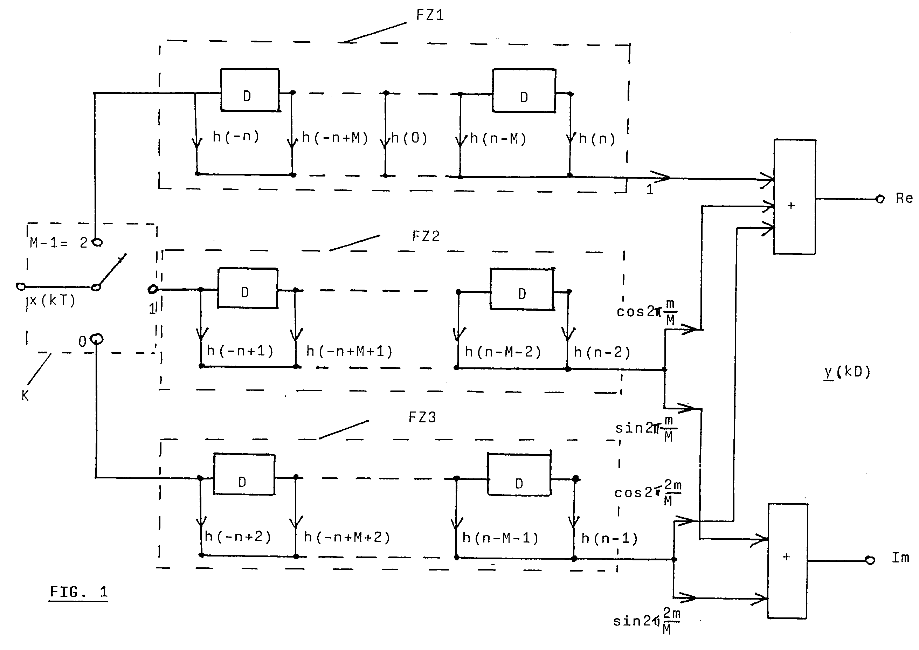

Fig. 1 zeigt für den Fall D/a/U eine allgemeine erfindungsgemäße Struktur für ein reelles Eingangs- und ein komplexes Ausgangssignal und zwar beispielhaft für den ungeraden Dezimationsfaktor M = 3, die die erfindungsgemäßen Vorteile aufweist. Ferner gelten bezüglich der Ausführungsform nach Fig. 1 die folgenden Vereinbarungen: Abtastzeit $T = 1/f_A$ und $D = MT$, sowie $N = pM + 1$, d.h. N ist ungerade für p geradzahlig und M = 3. Ferner gilt $\varphi_0 = 0$ und $n = (N-1)/2$. Die einzelnen parallelen Filterzweige FZ der Polyphasenstruktur des Filters weisen reelle Koeffizienten auf wie im Fall eines reellen Filters. Der Übergang zu einem komplexen Ausgangssignal ergibt sich durch wenige den Zweigfiltern nachgeschaltete Multiplizierer, durch deren Wert (das Argument) die BP-Mittenfrequenz festgelegt ist. Die Koeffizienten (Impulsantwort) des komplexen Filters berechnen sich nach Gl. 3.

Aus Fig. 1 ist ersichtlich, daß in der linken Bildhälfte das FIR-Prototypfilter als Polyphasenstruktur (PP) mit den reellen Koeffizienten h(k) realisiert ist, während der komplexe Drehfaktor rechts davon separat realisiert ist.

Wesentlich für die Aufwandseinsparung ist nun, daß einerseits die komplexen Drehfaktoren (Realteil: cos(.) ; Imaginärteil: sin(.) ) für alle Koeffizienten eines Zweigfilters identisch sind und daß andererseits die Nullphase $\varphi_0$ in obiger Beziehung so gewählt ist, daß der Drehfaktor das PP-Zweigfilter mit dem mittleren Koeffizienten h(0) entweder rein reell oder rein imaginär ist (In dem Beispiel der Fig.1 ist I eine Viererzahl, zb. 0)

Das beispielhaft dargestellte Filter betrifft den Fall M = 3, d.h. M ist ungerade. Entsprechende der Polyphasenstruktur weist das Filter demnach 3 Filterzweige FZ1, FZ2, FZ3 auf, die über einen Kommutator K, der mit der Abtastfrequenz $f_A$ die Filterzweige FZ1, FZ2, FZ3 mit Werten der zu filternden Funktion versorgt. Ein Filterzweig, beispielsweise FZ1 für M-1 = 2 , besteht in bekannter Schreibweise aus Verzögerungsgliedern D, deren Anzahl von der Filterlänge N abhängt. In den entsprechenden Filterzweigen erfolgt die Verknüpfung der entsprechenden reellen Filterkoeffizienten h(k) mit den Funktionswerten (senkrechte Pfeile) und deren Summation. Eine anschließende Multiplikation der Ausgangswerte der Filterzweige FZ mit den komplexen Drehfaktoren und deren Verknüpfung entsprechend der Fig. 1 ergibt die Komponenten des komplexen Ausgangssignals.

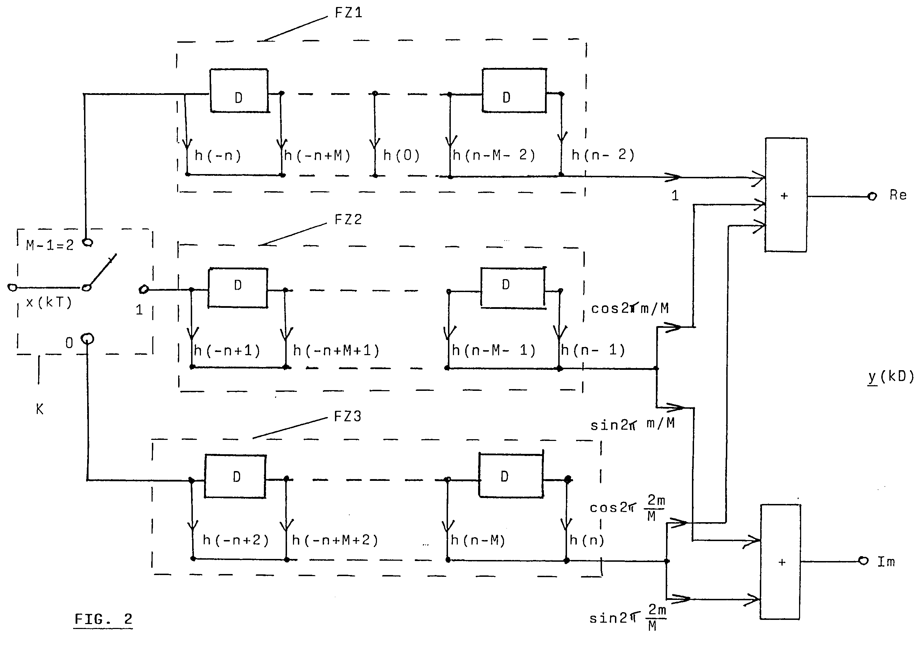

Fig. 2 zeigt für den Fall D/a/G eine allgemeine erfindungsgemäße Struktur eines Bandpaß-Filters für ein reelles Eingangs- und ein komplexes Ausgangssignal beispielhaft anhand des ungeraden Dezimationsfaktor $M = 3$, $N = pM$ mit N und p gerade sowie $\varphi_0 = 0$, $n = N/2$, $T = 1/f_A$ und $D = MT$, der die erfindungsgemäßen Vorteile aufweist. Die einzelnen Filterzweige entsprechend der Polyphasenstruktur weisen reelle Koeffizienten auf wie im Fall eines reellen PP-Filters. Der Übergang zu einem komplexen Ausgangssignal ergibt sich durch wenige den Zweigfiltern nachgeschaltete Multiplizierer, durch deren Wert (das Argument) die BP-Mittenfrequenz festgelegt ist. Die Koeffizienten (Impulsantwort) des komplexen Filters ergeben sich abgeleitet von einem reellen FIR-Prototypfilter h(k) entsprechend der Gl. 3, wobei sich der Unterschied zu dem Filter der Fig. 1 in der Koeffizientenindizierung folgendermaßen ausdrückt: $k \in \{ -N/2,..., -1, 0, 1,..., (N/2)-1 \}$ .

Aus Fig. 2 ist ersichtlich, daß in der linken Bildhälfte das FIR-Prototypfilter als Polyphasenstruktur (PP) mit den reellen Koeffizienten h(k) realisiert ist, während die komplexen Drehfaktoren rechts davon separat realisiert sind. Auch in diesem Fall sind die komplexen Drehfaktoren (Realteil: cos(.) ; Imaginärteil: sin(.) ) für alle Koeffizienten eines Zweigfilters identisch und weiterhin wurde auch hier die Nullphase $\varphi_0$ in obiger Beziehung so gewählt, daß der Drehfaktor das PP-Zweigfilters mit einem der beiden mittleren Koeffizienten h(0) entweder rein reell oder rein imaginär ist. (In dem Beispiel der Fig.2 gilt wie in Fig. 1: $l = 4i$ mit $i = 0, 1, 2, ...$)

Das Ausführungsbeispiel der Fig. 2 entspricht dem Fall $M = 3$ bei einem Filter mit gerader Filterlänge. Die Darstellung entspricht derjenigen der Fig. 1 mit drei reellwertigen Filterzweigen FZ1, FZ2, FZ3, deren Ausgangswerte mit den in der Fig. 2 dargestellten komplexen Drehfaktoren gewichtet werden und durch entsprechende Addition zu dem komplexen Ausgangssignal verknüpft werden.

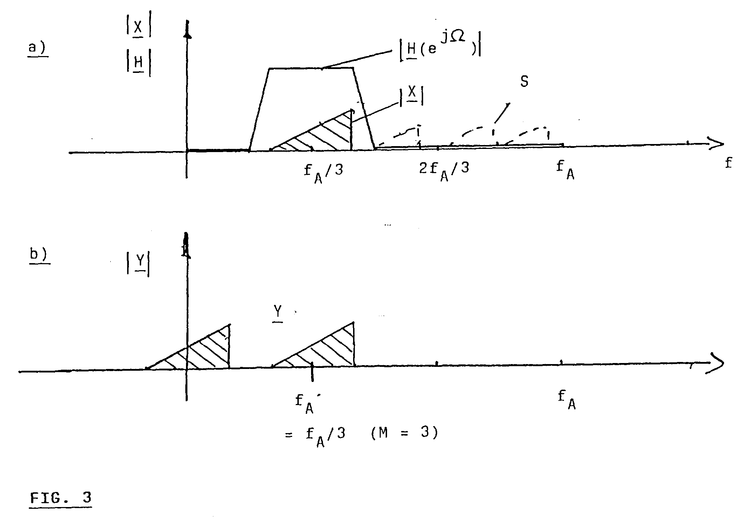

Die Figuren 3a und 3b zeigen die Wirkung des erfindungsgemäßen Bandpaßfilters auf ein komplexwertiges Eingangssignal. In Fig. 3a wird das Eingangsspektrum $|\underline{X}(e^{j\Omega})|$ (Darstellung des Betrags), das bei $mf_A/M$ mit $m = 1$ zentriert ist, mit der Übertragungsfunktion $|\underline{H}(e^{j\Omega})|$ gefiltert und im Zusammenhang mit der Dezimation (auch wieder beispielhaft für $M = 3$) frequenzverschoben. Charakteristisch für den bisher behandelten Fall a ist, daß das ursprünglich bei $mf_A/M$ zentrierte Nutzspektrum stets nach der resultierenden Mittenfrequenz $f = 0$ (Basisband) verschoben ist, wie dies in der Fig. 3b dargestellt ist. Mit S wird der Sperrbereich verdeutlicht.

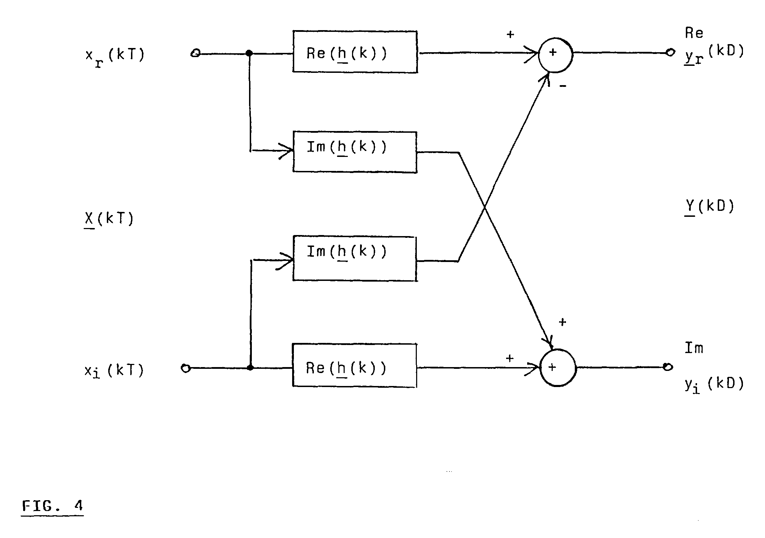

Fig. 4 zeigt das Blockschema eines erfindungsgemäßen Bandpaß-Filters, der ein komplexes Eingangssignal zu einem dezimierten komplexen Ausgangssignal verarbeitet. In diesem Fall sind zwei Strukturen gemäß Fig.1 oder der Fig.2, je nachdem ob eine gerade oder eine ungerade Filterlänge N vorliegt, zu einer Gesamtschaltung gemäß der Fig. 4 zusammenzufügen. Mit anderen Worten, die mit Re($\underline{h}$(k)) und Im($\underline{h}$(k)) bezeichneten Struktur beispielsweise der reellen Eingangsvariable bedeutet einen Filter entsprechend der Fig. 1 oder Fig. 2. Auch in diesem Fall eines Filters zur Verarbeitung rein komplexer Eingangssignale in komplexe Ausgangssignale ergeben sich hinsichtlich des vereinfachten Schaltungsaufwands die selben Vorteile wie bei den Lösungen entsprechend der Fig. 1 bzw. der Fig. 2. Beispielsweise sind dem Block Re{$\underline{h}$(k)} alle die Operationen der Fig. 1 bzw. Fig. 2 zugeordnet, die ausgehend von dem Eingangssignal einen Beitrag zum Realteil des Ausgangssignal liefern. Entsprechendes gilt für den Block Im{$\underline{h}$(k)}. Schließlich ist zu beachten daß beide Blöcke insgesamt zwei Mal in Fig. 4 eingesetzt sind und eine Verkreuzung des oberen Filterblocks mit dem unteren Filterblock stattfindet.

Soll ein komplexes Eingangssignal zu einem dezimierten reellen Ausgangssignal verarbeitet werden, so sind von der in Fig. 4 beschriebenen Struktur alle die Operationen zu eliminieren, die den Imaginärteil des Ausgangssignals bilden.

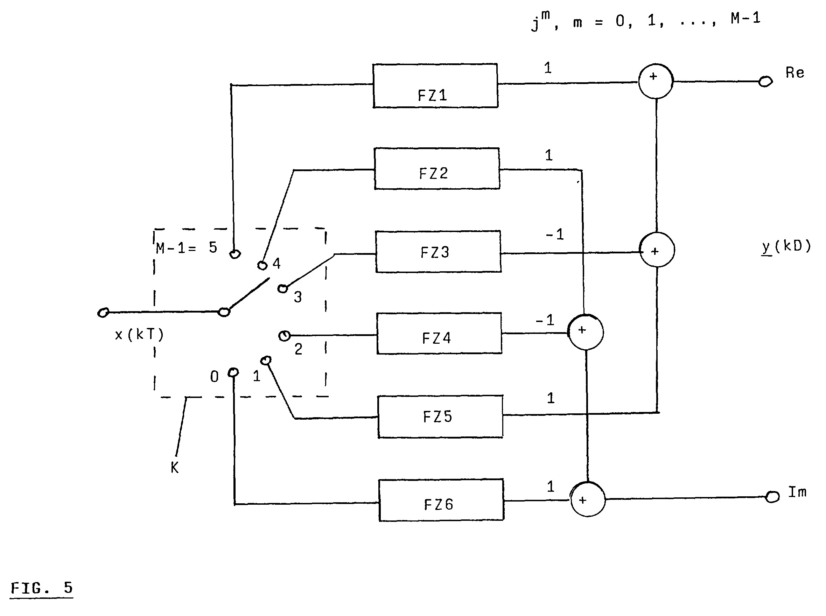

Im folgenden werden Sonderfälle (Fälle b und c) behandelt, wobei beispielhafte bevorzugte Ausführungsformen in den Figuren 5 - 8 dargestellt sind.

In diesen Sonderfällen ist die BP-Mittenfrequenz auf die in Gl. 2 angegebenen Werte beschränkt. Damit ergeben sich die komplexen Filterkoeffizienten zu (i,k,l ganzzahlig):

$$\underline{h}(k) = h(k) \, e^{j(2\pi k f_m/f_A + \varphi_0)}$$
$$= h(k) \, e^{j(ki + l)\pi/2}$$
$$= h(k) \, j^{ki + l} ,$$

wobei

$$\varphi_0 = l\pi/2 \text{ mit } l \in \{..., -1, 0, 1, ...\} \text{ gilt und}$$

$$k \in \{ -(N-1)/2,..., -1, 0, 1,..., (N-1)/2\} \text{ für den Fall U, sowie}$$

$k \in \{ -N/2,..., -1, 0, 1,..., (N/2)-1 \}$ für den Fall G.

Die Konsequenz dieser Beziehung ist, daß die Koeffizientenwerte $\underline{h}(k)$ entweder rein reell oder rein imaginär sind und zudem alle Drehfaktoren den Betrag 1 aufweisen. Somit besteht ein komplexes Bandpaßfilter gemäß der Erfindung mit den für die Fälle b und c zulässigen Mittenfrequenzen aus dem PP-Prototypfilter mit reellen Koeffizienten und einer vorzeichenbehafteten Zusammenfassung der PP-Filterzweigausgangssignale zum Realteil bzw. Realteil des komplexen Ausgangssignals.

Die Fälle b,c sind in Fall a enthalten wenn M eine Viererzahl ist; d.h. die Frequenzverschiebung erfolgt stets nach f = 0. Dies ist unabhängig davon, ob die Filterlänge $N$ gerade oder ungerade ist; siehe Fig. 3.

Fig. 5 zeigt einen beispielhaften Bandpaß-Filter für den Fall b (M gerade), der gegenüber dem allgemeinsten Fall a eine aufwandsgünstigere Struktur verwirklicht, die selbstverständlich auch für Fall a mit den BP-Mittenfrequenzen der Fälle b,c gilt. Für den Polyphasenfilter nach Fig. 5 gelten die folgenden Vereinbarungen: $M = 4m + 2$, M gerade, $f_m = i(f_A/4)$ mit i = 1, Nullphase $\varphi_0 = 0$ (l = 0), $f_A = 1/T$, $D = MT$. Aufgrund der Wahl M = 6 umfaßt der Filter sechs Filterzweige FZ1,..., FZ6, wobei jeder Filterzweig FZ1,..., FZ6 eine Filterzweigstruktur entsprechend einem Filterzweig der Fig. 1 oder 2 hat, die nach der reellen Operation mit den komplexen Drehfaktoren versehen werden. Aus Vereinfachungsgründen kann daher auf eine genaue Erläuterung der Filterzweige an dieser Stelle verzichtet werden. Im Beispielsfall sind diese wegen der Nullphase entweder 1 oder -1. Charakteristisch ist, daß (alternierend) jedes Zweigfilter des PP-Prototypfilters entweder nur zum Realteil oder nur zum Imaginärteil des Ausgangssignals beiträgt. Die das spezielle Beispiel kennzeichnenden Parameter sind in Fig. 5 angegeben. Wählt man eine andere Mittenfrequenz (i) oder eine andere Nullphase (l), so ändern sich die Vorzeichenkombinationen im ausgangsseitigen Addierernetzwerk.

Die Struktur für ein komplexes Eingangssignal oder ein reelles Ausgangssignal bei komplexem Eingangssignal ergibt sich in diesem Fall wiederum wie im Zusammenhang mit Fig. 4 beschrieben wurde, d.h. man koppelt zwei entsprechende Filterblöcke für ein reelles Eingangssignal und erhält so einen Filter für ein komplexes Eingangssignal. Eine genaue Erläuterung des Sachverhalts kann daher hier entfallen.

Dasselbe gilt für den Fall einer Abtastratenerhöhung. In diesem Fall wird eine übliche Schaltungstransponierung vorgenommen.

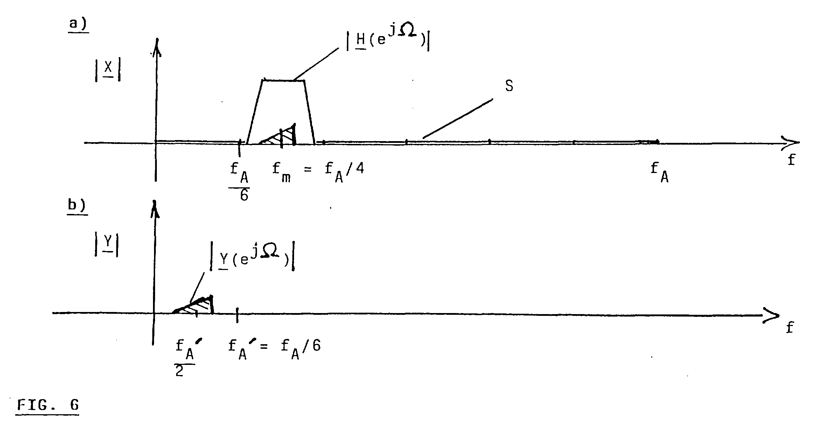

Figuren 6a und 6b zeigen schematisch die Wirkung eines Bandpaß-Filters der Fig. 5, bei dem (Fall b) das Filterausgangsspektrum bei einer kleineren Mittenfrequenz zu liegen kommt, die für komplexe Koeffizienten nicht den Wert Null hat. Die verwendeten Parameter haben die folgenden Werte: M = 6, $f_m = i(f_A/4)$ (i = 1). Mit S wird der Sperrbereich bezeichnet. Für die Mittenfrequenzlage nach GL. 2 des dezimierten komplexen Ausgangssignal ergibt sich aus der Eingangslage (M = 4m+2):

$$f_m = i(f_A/4) = i\,(M/4) \cdot (f_A/4)$$
$$= i(M/4)f'_A$$
$$= i(m+1/2)f'_A$$

$$\Rightarrow f_m' = f'_A/2$$

wobei sich die gestrichenen Größen auf das Signal am Filterausgang bei der um den Faktor $M$ verminderten Abtastrate beziehen. Offensichtlich ist das Ausgangsspektrum für i = 1 oder 3 bei der halben Ausgangsabtastfrequenz zentriert, im Fall i = 2 bei f = 0 wie im Fall a. Der Fall i = 2 nimmt im Rahmen des Falls b eine Sonderstellung ein: 1) Für Nullphasen, die durch gerade Werte von l festgelegt sind, ergibt sich für ein reelles (imaginäres) Eingangssignal ein reelles (imaginäres) Ausgangssignal. Die Filterung eines komplexen Eingangssignals ist dadurch charakterisiert, daß in der allgemeinen Struktur Fig. 4 die Kreuzverbindungen, die Blöcke Im$\{\underline{h}(k)\}$, identisch verschwinden. 2) Für Nullphasen, die durch ungerade Werte von l festgelegt sind, ergibt sich für ein reelles (imaginäres) Eingangssignal ein imaginäres (reelles) Ausgangssignal. Die Filterung eines komplexen Eingangssignals ist dadurch charakterisiert, daß in der allgemeinen Struktur Fig. 4 die Direktverbindungen vom Eingang zum Ausgang, die Blöcke Re$\{\underline{h}(k)\}$, identisch verschwinden.

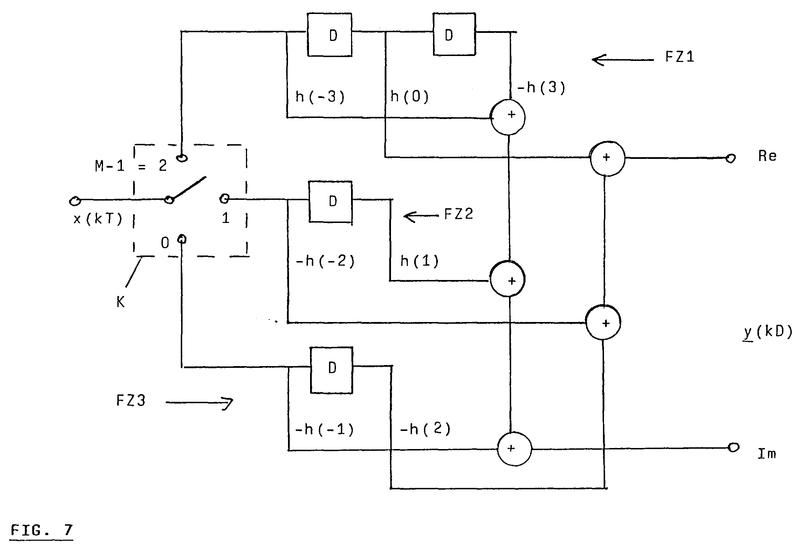

Fig. 7 zeigt beispielhaft für den Fall c (M ungerade), die hierfür resultierende, gegenüber dem allgemeinsten Fall a aufwandsgünstigere Struktur. Die verwendeten Parameter lauten: M = 3, $f_m = i(f_A/4)$ (i = 1), $\varphi_0 = 0$ (l = 1), $T = 1/f_A$ und $D = MT$. Charakteristisch ist, daß jedes Zweigfilter des PP-Prototypfilters sowohl zum Realteil als auch zum Imaginärteil des Ausgangssignals beiträgt (wiederum ohne zusätzliche Multiplikationen für die komplexen Drehfaktoren). Dabei tragen die Koeffizienten der PP-Zweigfilter abwechselnd zum Real- und zum Imaginärteil des Ausgangssignals bei. Die das spezielle Beispiel kennzeichnenden Parameter sind in Fig. 7 angegeben. Wählt man eine andere Mittenfrequenz (i) oder eine andere Nullphase (l), so ändern sich die Vorzeichenkombinationen in den Addierernetzwerken bzw. der Koeffizienten, denen die Vorzeichen zugeordnet wurden.

Im dargestellten Fall mit den Parametern M = 3, $f_m = i(f_A/4)$ und $\varphi_0 = 0$ vereinfacht sich das aus drei parallelen Filter-Zweigen FZ1, FZ2, FZ3 bestehende Netzwerk, wobei der Filterzweig FZ1 für M-1 = 2 wegen der Wahl N = 7 (p =

2, N = Mp + 1 = 7 ) nur noch zwei Verzögerungsglieder D umfaßt, während die anderen beiden Filterzweige FZ2, FZ3 nur jeweils ein Verzögerungsglied umfassen.

Die Struktur für ein komplexes Eingangssignal oder reelles Ausgangssignal bei komplexem Eingangssignal ergibt sich wiederum entsprechend der in Fig. 4 dargestellten Struktur und wird daher hier nicht wiederholt erläutert.

Entsprechend läßt sich der Fall der Abtastratenerhöhung mit Hilfe der Schaltungstransponierung bilden.

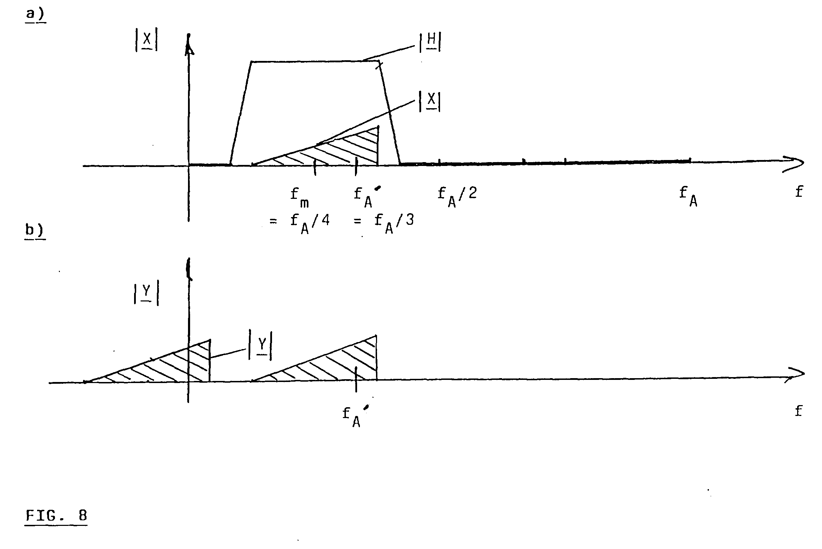

Figuren 8a und 8b zeigen die Wirkung eines Filters nach Fig. 7, d.h. Fall c, Das Filterausgangsspektrum kommt bei einer kleineren Mittenfrequenz zu liegen, die generell nicht den Wert Null hat.

Aufwandsgünstige Prototypfilter zur Abtastratenänderung sind die sog. M-tel-Bandfilter. Sie sind dadurch charakterisiert, daß die Filterlänge N ungerade, der mittlere Koeffizient h(0) = 1/M (im nichtskalierten Fall), und die Koeffizienten h(k) = 0 für k = $\pm$M, $\pm$2M, $\pm$3M, ... sind. Die Multiplizierer für die Nullkoeffizienten können entfallen; dadurch vereinfacht sich genau ein Zweigfilter aller vorgenannter PP-Strukturen zu einer einfachen Verzögerungskette, deren Ausgangs (oder Eingangs) - signal mit dem Koeffizienten h(0) = 1/M bewertet ist.

Als PP-Prototypfilter können auch identische Mittelungsfilter kaskadiert werden, wobei alle Teilfilterkoeffizienten den Wert 1 aufweisen. Mit Hilfe des polynomischen Satzes wird hiervon eine geschlossene FIR-Impulsantwort abgeleitet, die dann als PP-Prototypfilter in die vorgenannten Filterstrukturen einsetzbar ist. Von besonderem Vorteil ist, wenn im Fall a die äquidistanten Pole der identischen Teilfilter bei $f_m = m f_A/M$ , m = 1,2,...,M-1, liegen (also wenn die Teilfilter M Koeffizienten oder ein ganzzahliges Vielfaches davon aufweisen), da dadurch eine besonders gute Sperrwirkung erzielt wird und somit Aliasstörungen wirksamst unterdrückt werden. Es kommt hinzu, daß die Koeffizienten dieses polynomischen Filters auch bei endlicher Koeffizientenwortlänge exakt darstellbar sind (Frequenzganggenauigkeit).

Alle bisher beschriebenen Strukturen, Schaltungsanordnungen und/oder Verfahren sind für die Abtastratenerhöhung einsetzbar, wenn eine vorgegebene Struktur zur Abtastratenverminderung den bekannten Gesetzen der Transponierung digitaler Filter unterworfen wird. Auf diese Weise ergeben sich entsprechende Anordnungen zur Abtastratenerhöhung. Die Zahl der Zustandsspeicher und Multiplizierer ist bei sich entsprechenden Strukturen identisch (transpositionsinvariante Eigenschaften).

**Bezugszeichenliste**

| K | Kommutator |
|---|---|
| FZ1 | Filterzweig 1 |
| FZ2 | Filterzweig 2 |
| FZ3 | Filterzweig 3 |
| FZ4 | Filterzweig 4 |
| FZ5 | Filterzweig 5 |
| FZ6 | Filterzweig 6 |
| S | Sperrbereich |

**Patentansprüche**

1. Polyphasenfilter mit komplexen Koeffizienten zum Umwandeln eines reellwertigen oder komplexen Eingangssignales $\underline{X}(kT_1)$ unter Veränderung der Abtastfrequenz $f_A$ um einen ganzzahligen Faktor M > 2, in ein komplexes Ausgangssignal $\underline{Y}(kT_2)$, wobei für $T_1 > T_2$ (Interpolation) $M = T_1/T_2$ und für $T_1 < T_2$ (Dezimation) $M = T_2/T_1$ gilt, **dadurch gekennzeichnet**, daß

seine komplexen Koeffizienten $\underline{h}(k)$ mit $k \in \{-(N-1)/2,.. ,-1,O,1, ..1)/2\}$ für ein Filter mit ungerader Filterlänge N und mit $k \in \{-N/2,...,-1,O,1, ... ,N/2\}$ für ein Filter mit gerader Filterlänge N, abwechselnd rein reelle und rein imaginäre Werte, also keine im üblichen Sinne komplexen Werte aufweisen, und daß die Impulsantwort eines Prototypfilters mit ausschließlich reellen Werten auf den komplexen Träger einer Frequenz $f_m = m f_A/M$ bzw. $f_m = i f_A/4$ moduliert wird, wobei für die Abtastfrequenz $f_A$ das Maximum der Kehrwerte von $T_1$ und $T_2$ genommen wird und daß die Nullphase ganze Vielfache von $\pi/2$ beträgt.

2. Polyphasenfilter nach Anspruch 1, **dadurch gekennzeichnet**, daß die Abtastfrequenz um einen Faktor M vermindert wird, wobei M eine ganze Zahl > 2 ist, und die komplexwertigen Koeffizienten $\underline{h}(k)$ mit $k \in \{-(N-1)/2,..., -1, 0, 1, ..., (N-1)/2\}$ für einen Filter mit ungerader Filterlänge N und mit $k \in (- N/2,..., -1, 0, 1, N/2-1\}$ für eine gerade Filterlänge N sich aus der Beziehung

$$\underline{h}(k) = h(k)\, e^{j(2\pi k f_m/f_A + \varphi_0)}$$
$$= h(k)\, e^{j(2\pi km/M + l\pi/2)}$$
$$= h(k)\, j^{l}\, e^{j2\pi km/M}$$

mit: $\varphi_0 = l\pi/2$ , $l \in \{..., -1, 0, 1, ...\}$ ergeben.

3. Polyphasenfilter nach Anspruch 1, **dadurch gekennzeichnet**, daß im Fall einer Bandpaß-Mittenfrequenz von $f_m = i f_A/4$ mit $i \in \{1, 2, 3\}$ sich die komplexen Filterkoeffizienten $\underline{h}(k)$ mit (i, l, k) ganzzahlig ergeben zu

$$\underline{h}(k) = h(k)\, e^{j(2\pi k f_m/f_A + \varphi_0)}$$
$$= h(k)\, e^{j(ki + l)\pi/2}$$
$$= h(k)\, j^{ki + l}$$

ergeben, wobei
$\varphi_0 = l\pi/2$ mit $l \in \{..., -1, 0, 1, ...\}$ gilt.

4. Polyphasenfilter nach Anspruch 2 oder 3, **dadurch gekennzeichnet**, daß die Eigenschaft $h(k) = h(-k)$ für alle $k$ gilt.

5. Polyphasenfilter nach einem der vorangegangenen Ansprüche, **dadurch gekennzeichnet**, daß der Filter im Falle eines Eingangssignals mit einer rein reellen oder rein imaginären Signalkomponente entsprechend der Polyphasenstruktur aus M parallel angeordneten, aus Verzögerungsgliedern bestehenden Filterzweigen besteht, denen entsprechende Eingangssignalwerte durch einen Kommutator zugeführt werden, wobei in den Filterzweigen die Verknüpfung der entsprechenden Werte des Eingangssignals mit den entsprechenden reellen Koeffizienten h(k) erfolgt, und zur Erzeugung des komplexen Ausgangssignals den Filterzweigen Multiplizierer nachgeschaltet sind, die den Ausgangswert des Filterzweiges mit dem entsprechenden komplexen Drehfaktor der Filterkoeffizienten verknüpft, durch deren Werte die Bandpaß-Mittenfrequenz festgelegt wird.

6. Polyphasenfilter nach Anspruch 5, **dadurch gekennzeichnet**, daß der Filter eine ungerade Filterlänge N aufweist, reellwertige Einganssignale verarbeitet und eine Dezimation um einen Faktor M mit M=3 aufweist, der Kommutator des Filters die Werte des Eingangssignals auf M=3 parallele Filterzweige aufteilt, wobei die Definition n=(N-1)/2 getroffen wird,

in den ersten aus Verzögerungsgliedern bestehenden Filterzweig die Verknüpfung der entsprechenden Eingangssignalwerte x(kT) mit den reellen Koeffizienten h(k) für $k \in \{-n, -n+M,..., 0, n-M, n\}$ ,
in dem zweiten Filterzweig die Verknüpfung der entsprechenden Eingangssignalwerte x(kT) mit den reellen Koeffizienten h(k) für $k \in \{-n+1, -n+M+1,..., n-2\}$ ,
in dem dritten Filterzweig die Verknüpfung der entsprechenden Eingangssignalwerte x(kT) mit den reellen Koeffizienten h(k) für $k \in \{-n+2, -n+M+2,..., n-1\}$,
zur Bildung des Realteils des Ausgangssignals der Ausgangswert des ersten Filterzweigs, der mit $\cos(2\pi m/M)$ multiplizierte Ausgangswert des zweiten Filterzweiges und der mit $\cos(4\pi m/M)$ multiplizierte Ausgangswert des dritten Filterzweiges einem ersten Addierer zugeführt wird, und
zur Bildung des Imaginärteils des Ausgangssignals der mit $\sin(4\pi m/M)$ multiplizierte Ausgangswert des zweiten Filterzweiges und der mit $\sin(2\pi m/M)$ multiplizierte Ausgangswert des dritten Filterzweiges einem zweiten Addierer zugeführt wird.

7. Polyphasenfilter nach Anspruch 5, **dadurch gekennzeichnet**, daß der Filter eine gerade Filterlänge N aufweist, reellwertige Eingangssignale verarbeitet und eine Dezimation um einen Faktor M mit M = 3 aufweist, der Kommutator des Filters die Werte des Eingangssignals auf M = 3 parallele Filterzweige aufteilt, wobei die Definition n = N/2 getroffen wird,

in den ersten aus Verzögerungsgliedern bestehenden Filterzweig die Verknüpfung der entsprechenden Eingangssignalwerte x(kT) mit den reellen Koeffizienten h(k) für $k \in \{-n, -n+M,..., 0, n-M-3, n-3\}$ ,
in dem zweiten Filterzweig die Verknüpfung der entsprechenden Eingangssignalwerte x(kT) mit den reellen Koeffizienten h(k) für $k \in \{-n+1, -n+M+1,..., n-2\}$ ,

in dem dritten Filterzweig die Verknüpfung der entsprechenden Eingangssignalwerte x(kT) mit den reellen Koeffizienten h(k) für k ∈ {-n+2, -n+M+2,..., n-1} ,

zur Bildung des Realteils des Ausgangssignals der Ausgangswert des ersten Filterzweigs, der mit $\cos(2\pi m/M)$ multiplizierte Ausgangswert des zweiten Filterzweiges und der mit $\cos(4\pi m/M)$ multiplizierte Ausgangswert des dritten Filterzweiges einem ersten Addierer zugeführt wird, und

zur Bildung des Imaginärteils des Ausgangssignals der mit $\sin(2\pi m/M)$ multiplizierte Ausgangswert des zweiten Filterzweiges und der mit $\sin(4\pi M/M)$ multiplizierte Ausgangswert des dritten Filterzweiges einem zweiten Addierer zugeführt wird.

8. Polyphasenfilter nach Anspruch 5, **dadurch gekennzeichnet**, daß im Fall von M ≠ einer Viererzahl, M gerade und $f_m = i(f_A/4)$ sowie $\varphi_0 = 0$ der Filter aus M Filterzweigen besteht, wobei die Filterzweige jeweils alternierend entweder zur reellen oder imaginären Komponente des Ausgangssignals beitragen.

9. Halbbandfilter nach Anspruch 5, **dadurch gekennzeichnet**, daß im Fall m ungerade und $f_m = i(f_A/4)$ sowie $\varphi_0 = 0$ der Filter aus M Filterzweigen besteht, wobei jeder Filterzweig sowohl zur reellen als auch zur imaginären Komponente des Ausgangssignals beiträgt.

10. Halbbandfilter nach einem der Ansprüche 5 - 9, **dadurch gekennzeichnet**, daß im Fall eines komplexen Eingangssignals für die reelle und die imaginäre Komponente des Eingangssignals der Filter aus zwei Teilfiltern besteht, wobei ein Teilfilter entsprechend dem Filter eines rein reellen oder rein imaginären Eingangssignals nach Anspruch 2 gebildet wird, und die Teilfilter zur Erzeugung der entsprechenden reellen oder imaginären Komponenten des Ausgangssignals verkreuzt sind.

11. Polyphasenfilter nach Anspruch 10, **dadurch gekennzeichnet**, daß im Fall eines reellwertigen Ausgangssignals die den Imaginärteils des Ausgangssignals betreffenden Operationen eliminiert, d.h. auf Null gesetzt werden, sind.

12. Polyphasenfilter nach einem der vorangegangenen Ansprüche, dadurch gekennzeichnet, daß die Filterlänge N ungerade ist, für den mittleren Koeffizient h(0) = 1/M gilt und für die Koeffizienten h(k) = 0 für k = ±M, ±2M, ±3M, ... gilt.

13. Polyphasenfilter mit komplexen Koeffizienten zum Umwandeln eines komplexwertigen Eingangssignals $\underline{X}$(kT) unter Erhöhung der Abtastfrequenz 1/T in ein komplexwertiges Ausgangssignal $\underline{Y}$(kT/M), **dadurch gekennzeichnet**, daß

der Filter durch eine transponierte Struktur nach einem der Ansprüche 2 - 12 gebildet wird.

FIG. 1

FIG. 2

FIG. 3

Re
$\underline{y}_r(kD)$

$\underline{Y}(kD)$

Im
$y_i(kD)$

$Re(\underline{h}(k))$

$Im(\underline{h}(k))$

$Im(\underline{h}(k))$

$Re(\underline{h}(k))$

$x_r(kT)$

$\underline{X}(kT)$

$x_i(kT)$

FIG. 4

FIG. 5

a)

$|\underline{X}|$

$|\underline{H}(e^{j\Omega})|$

S

$\dfrac{f_A}{6}$    $f_m = f_A/4$    $f_A$    f

b)

$|\underline{Y}|$

$|\underline{Y}(e^{j\Omega})|$

$\dfrac{f_A'}{2}$    $f_A' = f_A/6$    f

FIG. 6

FIG. 7

a)

$|\underline{X}|$

$|\underline{H}|$

$|\underline{X}|$

$f_m$    $f_A'$    $f_A/2$      $f_A$    f

$= f_A/4$   $= f_A/3$

b)

$|\underline{Y}|$

$|\underline{Y}|$

$f_A'$    f

FIG. 8